# EUROPÄISCHE PATENTSCHRIFT

(11) **EP 0 590 303 B1**
(45) Veröffentlichungstag und Bekanntmachung des Hinweises auf die Patenterteilung: **13.11.1996**
(21) Anmeldenummer: 93113560.2
(22) Anmeldetag: 25.08.1993
(51) Int. Cl.: H03K 17/13, G01R 19/175, H03K 5/153

(54) **Integrierbarer Nullpunktdetektor**
Integrable zero-point detector
Détecteur de passage à zéro intégrable

(30) Priorität: 30.09.1992 DE 4232875
(43) Veröffentlichungstag der Anmeldung: 06.04.1994
(73) Patentinhaber: SIEMENS AKTIENGESELLSCHAFT, 80333 München (DE)
(72) Erfinder: Draxelmayr, Dieter, Dr. Dipl.-Ing., A-9500 Villach (AT)

(56) Entgegenhaltungen:
- EP-A- 0 335 460
- US-A- 4 622 478
- US-A- 4 704 544
- PATENT ABSTRACTS OF JAPAN vol. 8, no. 149 (E-255) (1586) 12. Juli 1984 & JP-A-59 054 319 (MATSUSHITA DENKI SANGYO K.K.) 29. März 1984

## Beschreibung

Die Erfindung betrifft einen integrierbaren Nullpunktdetektor.

Nullpunktdetektoren werden zur Bestimmung des Nulldurchganges bei Wechselspannungen verwendet. Ein konkreter Anwendungsfall ist der Einsatz in sogenannten Dimmerschaltungen, die beispielsweise aus einem Triac und einer entsprechenden Ansteuerschaltung bestehen.

In Dimmerschaltungen wird der Nulldurchgang der Netzwechselspannung aus zwei Gründen erfaßt. Zum einen liefert der Netznulldurchgang die Phaseninformation, aus der die Zündwinkel abgeleitet werden. Zum anderen ist ein Zünden bei Nullspannung im allgemeinen unerwünscht, da bei gezündetem Triac ein nochmaliger Zündimpuls sinnlos ist. Er kann sogar störend sein, weil dadurch die Phaseninformation möglicherweise verfälscht wird.

Eine integrierbare Halbleiterschaltung zur Ansteuerung von Triacs, die einen Fensterkomparator mit kleiner Fensterbreite um den Nullpunktdetektor aufweist, ist unter anderem aus der DE-PS 31 14 433 bekannt. Wenn aber die Wechselspannung, deren Nullpunkt detektiert werden soll, die Versorgungspotentiale der den Nullpunktdetektor enthaltenen integrierten Schaltung überschreitet, ist eine geeignete Schaltung zur Spannungsbegrenzung erforderlich. Eine derartige Begrenzerschaltung ist beispielsweise in der DE-OS 37 17 922 beschrieben. Dabei ist der Detektoreingang über je eine in Sperrichtung geschaltete Diode an die beiden Versorgungspotentiale der integrierten Schaltung angeschlossen. Zur Verhinderung eines dabei auftretenden Latch-Up-Effektes durch Injektion von Minoritätsträgern sind Schutzmaßnahmen wie z.B. dünne Epitaxie-Schichten, große Abstände zwischen den einzelnen Bauelementen auf dem Halbleiterchip oder Schutzringe erforderlich.

Aufgabe der Erfindung ist es, einen einfach zu realisierenden integrierbaren Nullpunktdetektor bereit zu stellen, der diesen Nachteil nicht aufweist.

Diese Aufgabe wird durch einen Nullpunktdetektor gemäß Patentanspruch 1 gelöst. Ausgestaltungen und Weiterbildungen der Erfindung sind Gegenstand von Unteransprüchen.

Die Erfindung wird nachfolgend anhand der in den Figuren der Zeichnung dargestellten Ausführungsbeispiele näher erläutert. Es zeigt:
- Figur 1: eine Ausführungsform eines erfindungsgemäßen Nullpunktdetektors,
- Figur 2: eine erste Ausführungsform einer Auswertelogik bei einem Nullpunktdetektor gemäß Figur 1,
- Figur 3: eine zweite Ausführungsform einer Auswertelogik bei einem Nullpunktdetektor nach Figur 1,
- Figur 4: eine Weiterbildung eines Stromspiegels bei einem Nullpunktdetektor nach Figur 1,
- Figur 5: eine alternative Eingangsbeschaltung bei der Ausführungsform nach Figur 1 und
- Figur 6: eine weitere Ausführungsform eines erfindungsgemäßen Nullpunktdetektors.

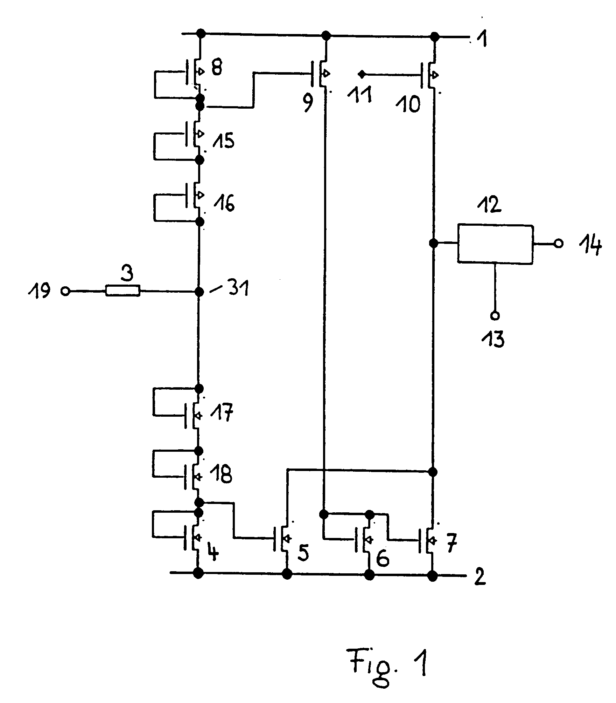

Der integrierbare Nullpunktdetektor nach Figur 1 enthält drei Stromspiegel, die ihrerseits jeweils aus zwei MOS-Transistoren 4, 5 bzw. 6, 7 bzw. 8, 9 bestehen. Dabei sind die Gateanschlüsse der beiden MOS-Transistoren 4 bis 9 jedes Stromspiegels, den jeweiligen Eingang bildend, miteinander gekoppelt, während der Drainanschluß jeweils eines MOS-Transistors 4, 6, 8 ebenfalls mit den gekoppelten Gateanschlüssen verbunden ist und der Drainanschluß des jeweils anderen MOS-Transistors 5, 7, 9 als Ausgang des jeweiligen Stromspiegels vorgesehen ist. Die MOS-Transistoren 4, 5 und 6, 7 des ersten bzw. zweiten Stromspiegels sind vom n-Kanal-Typ und die MOS-Transistoren 8, 9 des dritten Stromspiegels vom p-Kanal-Typ. Demzufolge wird bei erstem und zweitem Stromspiegel von einem anderen Bezugspotential als beim drittem ausgegangen. Somit sind die Sourceanschlüsse der MOS-Transistoren 4 bis 7 an ein negatives Versorgungspotential 2 und die MOS-Transistoren 8 und 9 an ein positives Versorgungspotential 1 angeschlossen.

Die Ausgänge von erstem und zweitem Stromspiegel sind miteinander gekoppelt und durch eine Last abgeschlossen. Die Last ist durch die Source-Drain-Strecke eines MOS-Transistors 10 vom p-Kanal-Typ gegeben, an dessen Gateanschluß ein Biaspotential 11 gelegt ist, oder alternativ durch einen Widerstand. Beim MOS-Transistor 10 ist daher der Sourceanschluß mit dem positiven Versorgungspotential 1 und der Drainanschluß mit den Drainanschlüssen der MOS-Transistoren 5 und 7 verbunden. Der Eingang des dritten Stromspiegels ist ebenso wie der Eingang des ersten Stromspiegels über einen Widerstand 3 mit einer zu detektierenden Wechselspannung 19 beaufschlagt.

Dazu sind in Weiterbildung der Erfindung die Gateanschlüsse der MOS-Transistoren 4, 5 bzw. 8, 9 unter Zwischenschaltung jeweils zweier Begrenzungselemente auf einen Knotenpunkt 31 geführt, der über den Widerstand 3 an die zu detektierende Wechselspannung 19 angeschlossen ist. Die Begrenzerelemente dienen dazu einerseits eine Überspannung vom Knotenpunkt 31 abzuleiten und andererseits den Eingangsstrom an die Stromspiegel 8, 9 bzw. 4, 5 weiterzuleiten. In Figur 1 sind dei Begrenzerelemente durch als Dioden betriebene MOS-Transistoren 17, 18 bzw. 15, 16 gegeben, deren Gate- und Drainanschlüsse jeweils miteinander verbunden sind. Die MOS-Transistoren 15, 16 sind dabei vom p-Kanal-Typ und die MOS-Transistoren 17, 18 vom n-Kanal-Typ. Schließlich ist eine Auswertelogik 12 vorgesehen, die aus einem Steuersignal 13 und dem an den miteinander gekoppelten Sourceanschlüssen der MOS-Transistoren 5, 7, 10 auftretenden Signal ein Ausgangssignal 14 erzeugt. Die Auswertelogik 12 dient dazu, ein Durchschalten des Steuersignals 13 beim Nulldurchgang der zu detektierenden Wechselspannung 19 zu verhindern bzw. zu verzögern.

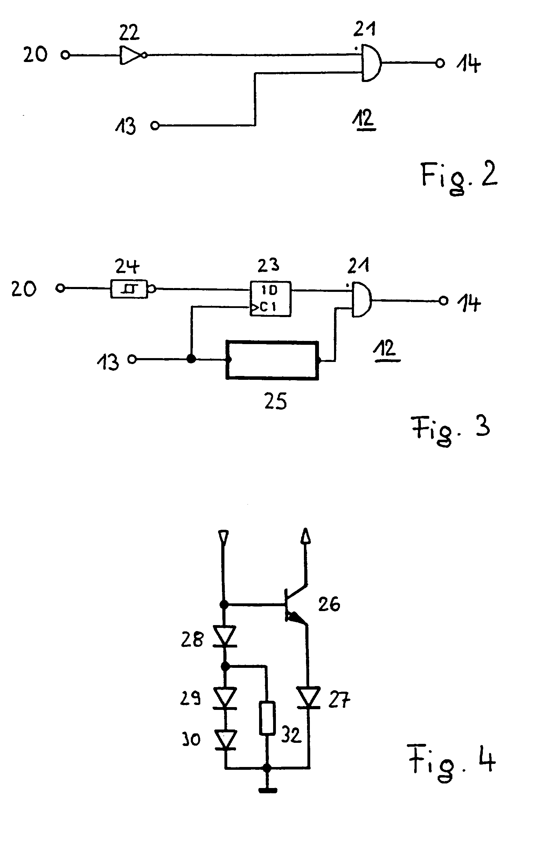

Eine erste Ausführungsform einer Auswertelogik 12 weist gemäß Figur 2 ein UND-Gatter 21 auf, an dessen einen Eingang das Steuersignal 13 angelegt ist und dessen anderer Eingang unter Zwischenschaltung eines Inverters 22 mit den miteinander gekoppelten Drainanschlüssen der MOS-Transistoren 5, 7, 10 verbunden ist. Eine weitere Ausführungsform einer Auswertelogik 12 ist gemäß Figur 3 dahingehend ausgestaltet, daß das Steuersignal 13 unter Zwischenschaltung eines Verzögerungselementes 25 auf einen Eingang des UND-Gatters 21 geführt ist und daß dem anderen Eingang des UND-Gatters 21 ein D-Flip-Flop 23 als Speicherelement vorgeschaltet ist, dessen Takteingang mit dem Steuersignal 13 beaufschlagt ist und dessen Dateneingang über einen invertierenden Schmitt-Trigger 24 mit den miteinander gekoppelten Drainanschlüssen der MOS-Transistoren 5, 7, 10 verbunden ist.

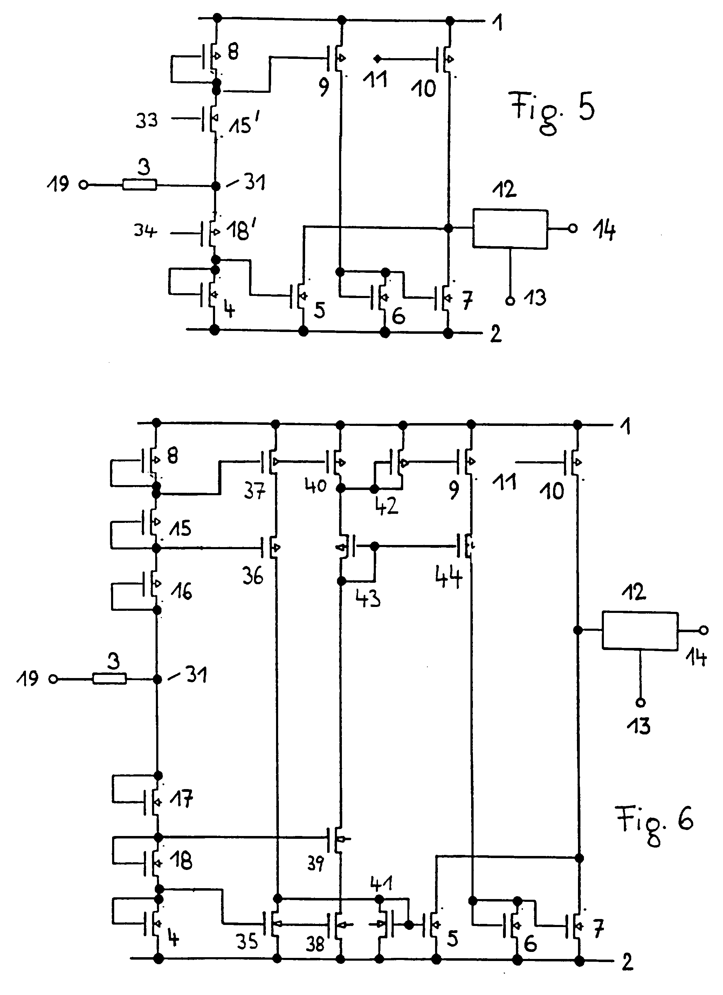

In Figur 4 ist eine alternative Ausführungsform eines Stromspiegels dargestellt. Dieser enthält einen Bipolartransistor 26, dessen Emitteranschluß über eine Diode 27 in Durchlaßrichtung mit dem entsprechenden Bezugspotential verbunden ist und dessen Kollektoranschluß den Ausgang des Stromspiegels bildet. Der Basisanschluß, der zugleich den Eingang des Stromspiegels darstellt, ist über drei in Reihe geschaltete Dioden 28, 29, 30 in Durchlaßrichtung mit dem Bezugspotential gekoppelt. Außerdem ist ein Widerstand 32 zwischen das Bezugspotential und den Abgriff zwischen den Dioden 28 und 29 geschaltet. Je nachdem, ob als Bezugspotential das positive oder das negative Versorgungspotential 1, 2 verwendet wird, wird als Bipolartransistor 26 ein pnp- oder npn-Transistor verwendet. Außerdem kann anstelle eines Bipolartransistors auch ein MOS-Transistor eingesetzt werden, ebenso wie Bipolartransistoren anstatt der MOS-Transistoren in dem Ausführungsbeispiel nach Figur 1 vorgesehen werden können. Figur 4 zeigt beispielhaft einen Stromspiegel mit einem npn-Transistor, so daß als Bezugspotential das negative Versorgungspotential 2 verwendet wird.
Das Auführungsbeispiel nach Figur 1 ist in Figur 5 dahingehend abgeändert, daß als Begrenzerelemente anstelle der MOS-Transistoren 15, 16 bzw. 17, 18 alternativ jeweils ein MOS-Transistor 15 bzw. 18' vom n-Kanal-Typ bzw. vom p-Kanal-Typ vorgesehen ist, an deren Gateanschlüsse jeweils ein Biaspotential 33 bzw. 34 angelegt ist. Die Biaspotentiale 33 und 34 können dabei sowohl unterschiedliche als auch identische Werte aufweisen.

In Weiterbildung der Erfindung ist in Figur 6 das Ausführungsbeispiel nach Figur 1 um eine Einrichtung zur Unterdrückung von Querströmen im Nullpunktdetektor erweitert. Diese Einrichtung enthält einen MOS-Transistor 35 vom n-Kanal-Typ und die MOS-Transistoren 36 und 37 vom p-Kanal-Typ, deren Laststrecken in Reihe zueinander zwischen das positive und das negative Versorgungspotential 2, 1 geschaltet sind. Das bedeutet, daß der Sourceanschluß des MOS-Transistors 35 mit dem negativen Versorgungspotential 2 und sein Drainanschluß mit dem Drainanschluß des MOS-Transistors 36 verbunden ist. Der Sourceanschluß des MOS-Transistors 36 ist mit dem Drainanschluß des MOS-Transistors 37 gekoppelt, an dessen Sourceanschluß wiederum das positive Versorgungspotential 1 angelegt ist. Die Gateanschlüsse der MOS-Transistoren 35, 36, 37 sind mit dem Drain- und Gateanschluß des MOS-Transistors 4 bzw. mit dem Drain- und Gateanschluß des MOS-Transistors 15 bzw. mit dem Drain- und Gateanschluß des MOS-Transistors 8 verbunden.

Weiterhin sind zwei MOS-Transistoren 38 und 39 vom n-Kanal-Typ und ein MOS-Transistor 40 vom p-Kanal-Typ vorgesehen, deren Laststrecken in Reihe zueinander zwischen das negative und das positive Versorgungspotential 2, 1 geschaltet sind und deren Gateanschlüsse mit dem Drain- und Gateanschluß des MOS-Transistors 4 bzw. mit dem Drain- und Gateanschluß des MOS-Transistors 18 bzw. mit dem Drain- und Gateanschluß des MOS-Transistors 8 gekoppelt sind. Ein durch Verbinden von Gate- und Drainanschluß als Diode betriebener MOS-Transistor 41 ist in Durchlaßrichtung der Drain-Source-Strecke des MOS-Transistors 35 parallel geschaltet, dessen Drainanschluß zudem mit dem Gateanschluß des MOS-Transistors 5 verbunden ist. In gleicher Weise ist ein als Diode betriebener MOS-Transistor 42 in Durchlaßrichtung der Source-Drain-Strecke des MOS-Transistors 40 parallel geschaltet, dessen Drainanschluß zudem mit dem Gateanschluß des MOS-Transistors 9 gekoppelt ist.

Schließlich weist die Querstromunterdrückungseinrichtung neben den in Kaskodeschaltung betriebenen MOS-Transistoren 36 und 39 zusätzliche Kaskodetransistoren, nämlich die MOS-Transistoren 43 und 44 vom p-Kanal-Typ auf, wobei zwischen die Drainanschlüsse der MOS-Transistoren 39 und 40 ein als Diode in Durchlaßrichtung betriebener MOS-Transistor 43 und zwischen den Sourceanschluß des MOS-Transistors 9 und den Gate- und Drainanschluß des MOS-Transistors 6 die Source-Drain-Strecke eines MOS-Transistors 44 geschaltet ist. Der Gateanschluß des MOS-Transistors 44 ist mit Gate- und Drainanschluß des MOS-Transistors 43 sowie mit dem Drainanschluß des MOS-Transistors 39 verbunden.

Mit den MOS-Transistoren 35, 37 bzw. 38, 40 wird je ein Stromsubtrahierer realisiert, die bewirken, daß die Querstromanteile der Ausgangsströme der Stromspiegel mit den MOS-Transistoren 4 und 5 bzw. 8 und 9, d.h. Anteile, die durch vom positiven zum negativen Versorgungspotential durch die Eingangskreise dieser beiden Stromspiegel fließenden Strömen hervorgerufen werden, jeweils eliminiert werden.

Nachdem zuvor der prinzipielle Aufbau eines erfindungsgemäßen Nullpunktdetektors erläutert worden ist, soll im folgenden auf dessen Funktionsweise näher eingegangen werden.

Wenn über den Widerstand 3 eine positive oder negative Spannung an dem Knotenpunkt 31 zwischen dem Widerstand 3, dem MOS-Transistor 16 und dem MOS-Transistor 17 auftritt, beginnen die zu Dioden verschalteten MOS-Transistoren 17, 18, 4 bzw. 8, 15, 16 zu leiten. Da die MOS-Transistoren 4 und 8 die Eingangskreise zweier Stromspiegel bilden, deren Ausgangskreise mit Hilfe eines weiteren Stromspiegels additiv miteinander gekoppelt sind, fließt unabhängig davon, ob die zu detektierende Wechselspannung 19 einen positiven oder negativen Spannungswert aufweist, ein Strom durch die Last, die durch die Source-Drain-Strecke des MOS-Transistors 10 gegeben ist. Die Größe des der Last, die beispielsweise ganz oder teilweise ein nichtlineares Verhalten aufweisen kann, des angebotenen Stromes hängt dabei direkt von der Eingangsspannung ab. Darüber hinaus wird durch die Eingangsbeschaltung mit den MOS-Transistoren 8, 15, 16, 17, 18, 4 die Spannung am Knotenpunkt 31 auf Werte kleiner der Versorgungsspannung geklemmt. Damit wird das Problem der Injektion von Minoritätsträgern beseitigt. Bei entsprechender Dimensionierung tritt außerdem beim Nulldurchgang eine relativ steile Flanke auf, da in diesem Spannungsbereich die Klemmung unwirksam ist. Die gesamte Anordnung arbeitet im Bereich des Nullpunktes als Verstärker, der unterhalb eines bestimmten, durch die Sourceströme der MOS-Transistoren 5 und 7 gegebenen Ausgangsstromes einen Spannungspegel erzeugt, der dem logischen Zustand Eins entspricht. Damit kann im Bereich des Nulldurchganges bzw. der Zustand bei gezündetem Triac eindeutig erkannt werden. Um dabei die Schaltflanke zu verbessern, kann, wie im Ausführungsbeispiel gezeigt, eine Komparatoreinheit wie etwa ein Schmitt-Trigger oder ein Inverter nachgeschaltet werden.

Die nachfolgende Auswertelogik ist dazu vorgesehen, einen evtl. zu diesem Zeitpunkt auftretenden Zündimpuls für den Triac zu unterdrucken und ihn zu anderen Zeiten durchzulassen. Dazu wird das Ausgangssignal des Inverters 22 mit dem Steuersignal 13 durch das UND-Gatter 21 verknüpft. Allerdings kommt es bei dieser, in Figur 2 der Zeichnung dargestellten Ausführungsform zu einer Zündimpulsverkürzung. Wenn nämlich beim Steuersignal 13 ein Zündimpuls auftritt und dadurch der Triac gezündet wird, wird in weiterer Folge die danachauftretende Nullspannung erkannt und ein noch anstehender Zündimpuls gesperrt. Bei entsprechender Anwendung kann damit eine Leistungsersparnis erreicht werden, da die Zündimulslänge optimiert wird. Bei der alternativen Ausführungsform nach Figur 3 wird der Zustand am Ausgang des Schmitt-Triggers 24 mit dem D-Flip-Flop 23 bei Auftreten des Zündimpulses durch das Steuersignal 13 abgespeichert. Im Falle des Nulldurchgangs sperrt das nachfolgende UND-Gatter 21 den über das Verzögerungselement 25 zugeführten Zündimpuls. Andernfalls wird der Zündimpuls weitergegeben.

Der vorstehend beschriebene Nullpunktdetektor kann sowohl in Bipolar-Technologie als auch in MOS-Technologie realisiert werden. Außerdem können die Stromspiegel durch an sich bekannte Maßnahmen, wie z.B. durch Einsatz von Emitterwiderständen oder Kaskodetransistoren, weiter verbessert werden. Es ist dabei auch möglich, wie in Figur 4 gezeigt, bei den Stromspiegeln bereits eine gewisse Komparatorwirkung oder allgemein ein nichtlineares Verhalten vorzusehen.

## Patentansprüche

1. Integrierbarer Nullpunktdektektor mit einem ersten und zweiten Stromspiegel (4 bis 7) des einen Leitungstyps, deren Ausgänge miteinander gekoppelt und durch eine Last (10) abgeschlossen sind, und
mit einem dritten Stromspiegel (8, 9) des anderen Leitungstyps, an dessen Eingang sowie an den Eingang des ersten Stromspiegels (4, 5) über einen Widerstand (3) eine zu detektierende Wechselspannung (19) gelegt ist und dessen Ausgang mit dem Eingang des zweiten Stromspiegels (6, 7) verbunden ist.

2. Nullpunktdetektor nach Anspruch 1,
**dadurch gekennzeichnet,**
daß den Eingängen von erstem und drittem Stromspiegel (4, 5; 8, 9) jeweils die Laststrecke eines Transistors (15', 18') vorgeschaltet ist, an dessen Steueranschluß ein Biaspotential (33, 34) angelegt ist.

3. Nullpunktdetektor nach Anspruch 1,
**dadurch gekennzeichnet,** daß den Eingängen von erstem und drittem Stromspiegel (4, 5; 8, 9) jeweils mindestens eine Diode (15 bis 18) vorgeschaltet ist.

4. Nullpunktdetektor nach einem der Ansprüche 1 bis 3,
**dadurch gekennzeichnet,** daß zwischen die Eingangskreise (4, 8) und Ausgangskreise (5, 9) von erstem und drittem Stromspiegel (4, 5; 8, 9) eine Querstromunterdrückungseinrichtung (35 bis 44) geschaltet ist.

5. Nullpunktdetektor nach Anspruch 4,
**gekennzeichnet durch** eine Querstromunterdrückungseinrichtung
mit einem ersten und zweiten Transistor (35, 37), deren Laststrecken in Reihe zueinander zwischen zwei Versorgungspotentiale (2, 1) geschaltet sind und deren jeweilige Steueranschlüsse mit dem Eingangskreis (4) des ersten Stromspiegels (4, 5) und des dritten Stromspiegels (8, 9) gekoppelt sind,
mit einem dritten und vierten Transistor (38, 40), deren Laststrecken in Reihe zueinander zwischen die zwei Versorgungspotentiale (2, 1) geschaltet sind und deren jeweilige Steueranschlüsse mit dem Eingangskreis (4) des ersten Stromspiegels (4, 5) und des dritten Stromspiegels (8, 9) gekoppelt sind,
mit einer ersten Diode (41), die der Laststrecke des ersten Transistors (35) parallel geschaltet ist und die mit dem Ausgangskreis (5) des ersten Stromspiegels (4, 5) gekoppelt ist und
mit einer zweiten Diode (42), die der Laststrecke des vierten Transistors (40) parallelgeschaltet ist und die mit dem Ausgangskreis (9) des dritten Stromspiegels (8, 9) gekoppelt ist.

6. Nullpunktdetektor nach Anspruch 5,
**dadurch gekennzeichnet**, daß die Querstromunterdrückungseinrichtung mindestens einen MOS-Transistor (36, 39, 43, 44) in Kaskodeschaltung aufweist.

7. Nullpunktdetektor nach einem der Ansprüche 1 oder 6,
**dadurch gekennzeichnet**, daß den miteinander gekoppelten Ausgängen von erstem und zweitem Stromspiegel (4 bis 7) eine Auswertelogik (12) nachgeschaltet ist, die aus einem Steuersignal (13) und dem an den miteinander gekoppelten Ausgängen der beiden Stromspiegel (6 bis 9) auftretenden Signal ein Ausgangssignal (14) erzeugt.

8. Nullpunktdetektor nach Anspruch 7,
**dadurch gekennzeichnet,** daß die Auswertelogik ein UND-Gatter (21) aufweist, an dessen einen Eingang das Steuersignal (13) angelegt ist und dessen anderer Eingang mit den gekoppelten Ausgängen von erstem und zweitem Stromspiegel (4 bis 7) verbunden ist.

9. Nullpunktdetektor nach Anspruch 8,
**dadurch gekennzeichnet,** daß das Steuersignal (13) unter Zwischenschaltung eines Verzögerungselementes (25) dem einen Eingang des UND-Gatters (21) zugeführt wird und daß dem anderen Eingang des UND-Gatters (21) ein Speicherelement (23) vorgeschaltet ist, an dessen Takteingang das Steuersignal (13) angelegt ist und dessen Dateneingang mit den gekoppelten Ausgängen von erstem und zweitem Stromspiegel (4 bis 7) verbunden ist.

10. Nullpunktdetektor nach einem der Ansprüche 7 bis 9,
**dadurch gekennzeichnet,** daß der Auswertelogik (12) ein Komparatorelement (22; 24) vorgeschaltet ist.

11. Nullpunktdetektor nach einem der Ansprüche 1 bis 10,
**dadurch gekennzeichnet,** daß mindestens einer der Stromspiegel ein nichtlineares Verhalten aufweist.

12. Nullpunktdetektor nach Anspruch 11,
**dadurch gekennzeichnet**, daß mindestens einer der Stromspiegel einen Transistor (26) aufweist, dessen gesteuerte Strecke zum einen mit dem Ausgang und zum anderen über eine Diode (27) mit einem Bezugspotential verbunden ist und dessen den Eingang bildender Steueranschluß über mindestens zwei in Reihe geschaltete weitere Dioden (28 bis 30) in Durchlaßrichtung mit dem Bezugspotential gekoppelt ist, wobei zwischen einen Abgriff der in Reihe geschalteten weiteren Dioden (28 bis 30) und das Bezugspotential ein Widerstand (32) geschaltet ist.

## Claims

1. Zero-point detector which can be integrated and has a first and a second balanced circuit (4 to 7) of the one conductance type, whose outputs are coupled to one another and are terminated by a load (10), and which has a third balanced circuit (8, 9) of the other conductance type, to whose input and to the input of the first balanced circuit (4, 5) an AC voltage (19) to be detected is applied via a resistor (3), and whose output is connected to the input of the second balanced circuit (6, 7).

2. Zero-point detector according to Claim 1, characterized in that the load path of a transistor (15', 18') is in each case connected upstream of the inputs of the first and the third balanced circuit (4, 5; 8, 9), a bias potential (33, 34) being applied to the control connection of said transistor (15' 18').

3. Zero-point detector according to Claim 1, characterized in that at least one diode (15 to 18) is in each case connected upstream of the inputs of the first and the third balanced circuit (4, 5; 8, 9).

4. Zero-point detector according to one of Claims 1 to 3, characterized in that a cross-current suppression device (35 to 44) is connected between the input circuits (4, 8) and output circuits (5, 9) of the first and the third balanced circuit (4, 5; 8, 9).

5. Zero-point detector according to Claim 4, characterized by a cross-current suppression device having a first and a second transistor (35, 37) whose load paths are connected in series with one another between two supply potentials (2, 1) and whose respective control connections are coupled to the input circuit (4) of the first balanced circuit (4, 5) and of the third balanced circuit (8, 9), having a third and a fourth transistor (38, 40) whose load paths are connected in series with one another between the two supply potentials (2, 1) and whose respective control connections are coupled to the input circuit (4) of the first balanced circuit (4, 5) and of the third balanced circuit (8, 9), having a first diode (41) which is connected in parallel with the load path of the first transistor (35) and which is coupled to the output circuit (5) of the first balanced circuit (4, 5), and having a second diode (42) which is connected in parallel with the load path of the fourth transistor (40) and which is coupled to the output circuit (9) of the third balanced circuit (8, 9).

6. Zero-point detector according to Claim 5, characterized in that the cross-current suppression device has at least one MOS transistor (36, 39, 43, 44) in a cascode circuit.

7. Zero-point detector according to one of Claims 1 or 6, characterized in that an evaluation logic device (12) is connected downstream of the outputs of the first and the second balanced circuit (4 to 7) which are coupled to one another, which evaluation logic device (12) produces an output signal (14) from a control signal (13) and the signal which occurs at those outputs of the two balanced circuits (6 to 9) which are coupled to one another.

8. Zero-point detector according to Claim 7, characterized in that the evaluation logic device has an AND gate (21) to one of whose inputs the control signal (13) is applied and whose other input is connected to the coupled outputs of the first and the second balanced circuit (4 to 7).

9. Zero-point detector according to Claim 8, characterized in that the control signal (13) is fed to one input of the AND gate (21) with the interposition of a delay element (25), and in that a storage element (23) is connected upstream of the other input of the AND gate (21), to the clock input of which storage element (23) the control signal (13) is applied, and whose data input is connected to the coupled outputs of the first and the second balanced circuit (4 to 7).

10. Zero-point detector according to one of Claims 7 to 9, characterized in that a comparator element (22; 24) is connected upstream of the evaluation logic device (12).

11. Zero-point detector according to one of Claims 1 to 10, characterized in that at least one of the balanced circuits has a non-linear behaviour.

12. Zero-point detector according to Claim 11, characterized in that at least one of the balanced circuits has a transistor (26) whose controlled path is connected on the one hand to the output and on the other hand via a diode (27) to a reference-earth potential, and whose control connection which forms the input is coupled via at least two series-connected further diodes (28 to 30) in the forward direction to the reference-earth potential, a resistor (32) being connected between a pick-off of the series-connected further diodes (28 to 30) and the reference-earth potential.

## Revendications

1. Détecteur de passage par zéro intégrable, comportant un premier et un deuxième miroirs de courant (4 à 7) de l'un des types de conductivité, dont les sorties sont couplées entre elles et fermées par une charge (10), et comportant un troisième miroir de courant (8, 9) de l'autre type de conductivité, à l'entrée duquel, ainsi qu'à l'entrée du premier miroir de courant (4, 5), une tension (19) alternative à détecter est appliquée par l'intermédiaire d'une résistance (3) et dont la sortie est reliée à l'entrée du deuxième miroir de courant (6, 7).

2. Détecteur de passage par zéro, suivant la revendication 1, caractérisé en ce qu'il est branché en amont des entrées du premier et du troisième miroirs de courant (4, 5; 8, 9) la section de charge d'un transistor (15', 18') à la borne de commande duquel est appliquée un potentiel (33, 34) de polarisation.

3. Détecteur de passage par zéro, suivant la revendication 1, caractérisé en ce qu'il est branché en amont des entrées du premier et du troisième miroirs de courant (4, 5; 8, 9) au moins une diode (15 à 18).

4. Détecteur de passage par zéro, suivant une des revendications 1 à 3, caractérisé en ce qu'il est branché entre les circuits (4, 8) d'entrée et les circuits (5, 9) de sortie du premier et du troisième miroirs de courant (4, 5; 8, 9) un dispositif (35 à 44) de suppression des composantes transversales du courant.

5. Détecteur de passage par zéro, suivant la revendication 4, caractérisé par un dispositif de suppression des composantes transversales du courant comportant un premier et un deuxième transistors (35, 37), dont les sections de charge sont branchées en série l'une par à l'autre entre deux potentiels (2, 1) d'alimentation et dont les bornes de commande associées sont couplées au circuit (4) d'entrée du premier miroir de courant (4, 5) et du troisième miroir de courant (8, 9), comportant un troisième et un quatrième transistors (38, 40), dont les sections de charge sont branchées en série l'une par à l'autre entre les deux potentiels (2, 1) d'alimentation et dont les bornes de commande associées sont couplées au circuit (4) d'entrée du premier miroir de courant (4, 5) et du troisième miroir de courant (8, 9), comportant une diode (41) qui est branchée en parallèle à la section de charge du premier transistor (35) et qui est couplée au circuit (5) de sortie du premier miroir de courant (4, 5), et comportant une deuxième diode (42) qui est branchée en parallèle à la section de charge du quatrième transistor (40) et est couplée au circuit (9) de sortie du troisième miroir de courant (8, 9).

6. Détecteur de passage par zéro, suivant la revendication 5, caractérisé en ce que le dispositif de suppression des composantes transversales du courant comporte au moins un transistor MOS (36, 39, 43, 44) en branchement cascode.

7. Détecteur de passage par zéro, suivant une des revendications 1 ou 6, caractérisé en ce qu'il est monté en aval des sorties, couplées entre elles, du premier et du deuxième miroirs de courant (4 à 7) une logique (12) d'exploitation qui produit, à partir d'un signal (13) de commande et du signal apparaissant aux sorties, couplées entre elles, des deux miroirs de courant (6 à 9) un signal (14) de sortie.

8. Détecteur de passage par zéro, suivant la revendication 7, caractérisé en ce que la logique (12) d'exploitation comporte une porte ET (21) à l'une des entrées de laquelle est appliqué le signal (13) de commande et dont l'autre entrée est reliée aux sorties couplées du premier et du deuxième miroirs de courant (4 à 7).

9. Détecteur de passage par zéro, suivant la revendication 8, caractérisé en ce que le signal (13) de commande est envoyé, avec interposition d'un élément (25) de retard, à une des entrées de la porte ET (21), et en ce qu'il est monté en amont de l'autre entrée de la porte ET (21) un élément (23) de mémorisation à l'entrée de cadence duquel est appliqué le signal (13) de commande et dont l'entrée de donnée est reliée aux sorties couplées du premier et du deuxième miroirs de courant (4 à 7).

10. Détecteur de passage par zéro, suivant une des revendications 7 à 9, caractérisé en ce qu'il est branché en amont de la logique (12) d'exploitation un élément (22; 24) comparateur.

11. Détecteur de passage par zéro, suivant une des revendications 1 à 10, caractérisé en ce qu'au moins un des miroirs de courant a un comportement non-linéaire.

12. Détecteur de passage par zéro, suivant la revendication 11, caractérisé en ce qu'au moins un des miroirs de courant comporte un transistor (26) dont la section commandée est reliée d'une part à la sortie et, d'autre part, par l'intermédiaire d'une diode (27), à un potentiel de référence et dont la borne de commande, formant l'entrée, est couplée, par l'intermédiaire d'au moins deux diodes (28 à 30) supplémentaires branchées en série dans le sens de conduction, au potentiel de référence, une résistance (32) étant branchée entre une prise des diodes (28 à 30) supplémentaires, branchées en série, et le potentiel de référence.
